# EUROPÄISCHE PATENTSCHRIFT

(11) **EP 1 570 280 B1**
(45) Veröffentlichungstag und Bekanntmachung des Hinweises auf die Patenterteilung: **26.04.2006**
(21) Anmeldenummer: 03813081.1
(22) Anmeldetag: 13.12.2003
(51) Int. Cl.: G01R 31/3185, G01R 31/316

(54) **SELBSTMARKIERUNGSVORRICHTUNG FÜR INTEGRIERTE SCHALTUNG SOWIE ZUGEHÖRIGE GEHÄUSTE INTEGRIERTE SCHALTUNG**
SELF-MARKING DEVICE FOR AN INTEGRATED CIRCUIT, AND ASSOCIATED HOUSED INTEGRATED CIRCUIT
DISPOSITIF DE NOTATION AUTOMATIQUE CONçU POUR UN CIRCUIT INTEGRE ET CIRCUIT INTEGRE SOUS BOITIER CORRESPONDANT

(30) Priorität: 14.12.2002 DE 10258511
(43) Veröffentlichungstag der Anmeldung: 07.09.2005
(73) Patentinhaber: Infineon Technologies AG, 81669 München (DE)
(72) Erfinder: ZETTLER, Thomas, 85635 Höhenkirchen-Siegertsbrunn (DE)
(74) Vertreter: Kindermann, Peter
(86) Internationale Anmeldenummer: PCT/DE2003/004224
(87) Internationale Veröffentlichungsnummer: WO 2004/055534

(56) Entgegenhaltungen:
- US-A- 4 961 053
- US-A- 5 248 936
- US-A- 5 789 932
- US-A- 6 091 079

## Beschreibung

Die vorliegende Erfindung bezieht sich auf eine integrierte Schaltung sowie eine zugehörige gehäuste integrierte Schaltung und insbesondere auf eine integrierte Schaltung mit verbesserter Testbarkeit.

Für die Qualitätssicherung bei der Fertigung von integrierten Halbleiterschaltungen sowie von gehäusten bzw. montierten integrierten Schaltungen ist ein wichtiger Testschritt die Bestimmung funktionierender noch unvereinzelter Chips auf einem Halbleiterwafer sowie der endgültige Test der fertig in einem Gehäuse verpackten Halbleiterbausteine. Die Testkosten für diese integrierten Halbleiterschaltungen bzw. Chips sowie für die endmontierten gehäusten integrierten Schaltungen machen einen wesentlichen Anteil der Gesamtkosten in der Halbleiterfertigung aus.

Hierbei verursacht insbesondere die stetig steigende Integrationsdichte von integrierten Halbleiterschaltungen eine Reihe von Problemen bei der Realisierung eines kostengünstigen, schnellen und zuverlässigen Produktionstests. Dies liegt einerseits daran, dass die Anzahl der internen Bauelemente einer integrierten Halbleiterschaltung deutlich schneller ansteigt als die Anzahl der an einem Gehäuse vorhandenen Anschlusspins. Dies führt zu einem Problem insbesondere der Beobachtbarkeit. Weiterhin steigen die typischen Systemfrequenzen, so dass ein Test unter Betriebsbedingungen immer kostenintensivere Hochleistungstester erfordert. Ebenso steigt häufig die Taktfrequenz nicht in gleichem Maße wie z.B. eine Anzahl von Speicherzellen eines im System integrierten Speichers. Dies bedeutet bei gleichen Test-Algorithmen eine absolut steigende Testzeit und damit steigende Testkosten pro Produkt.

Ebenso stellt die Konsistente Übertragung der Testergebnisse in derzeit unterschiedlichen Standards eine logistische Herausforderung dar, insbesondere bei der Nutzung von verschiedenen Subkontraktoren für z.B. eine getrennte Wafer-Fertigung und Montage.

Eine Reduktion von Testzeit und Test- sowie Logistik-Kosten kann also am effektivsten durch einen kombinierten Ansatz unter Einbeziehung von Schaltungs-Design, Testkonzept, Tester und Montage-Aufbau und Logistik erreicht werden.

Ein derartiges verbessertes Testverfahren ist beispielsweise aus der Druckschrift EP 1 178 323 bekannt, wobei zu testende integrierte Schaltungen jeweils integrierte Selbsttesteinheiten (sogenannte BISTs) aufweisen und das Durchführen des Selbsttests zu einem früheren Zeitpunkt durchgeführt wird als das Auslesen der Testergebnisse des Selbsttests.

Aus den Dokumenten US 4 961 053 A vom 2. Oktober 1990, US 5 248 936 A vom 28. September 1993, US 6 091 079 A vom 18. Juli 2000 und US 5 789 932 A vom 4. August 1998 ist eine elektrisch bzw. optisch auslesbare Markierung bekannt.

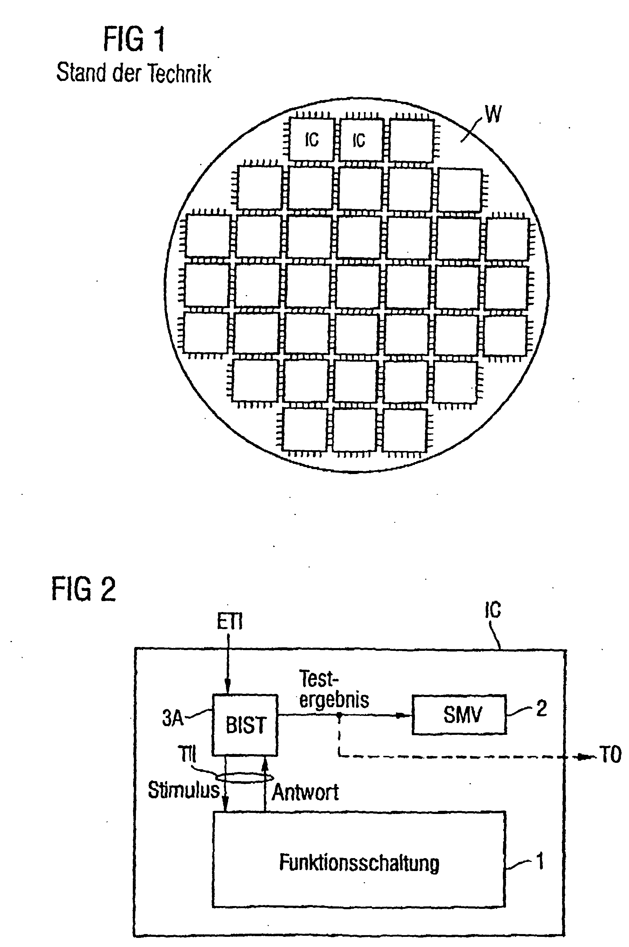

Figur 1 zeigt eine vereinfachte Draufsicht eines Halbleiterwafers W mit einer Vielzahl von darauf ausgebildeten integrierten Halbleiterschaltungen IC gemäß diesen herkömmlichen Verfahren. Bereits auf Waferebene werden hierbei alle integrierten Schaltungen IC auf einem Halbleiterwafer W mit einer Spannungsversorgung versorgt, so dass die in der Vielzahl von integrierten Schaltungen IC ausgebildeten Selbsttesteinheiten bereits zu diesem Zeitpunkt einen Selbsttest zeitgleich durchführen können. Auf diese Weise muss lediglich die erhaltene Testinformation bzw. das Testergebnis beispielsweise mittels einzelner Kontaktierung ausgelesen werden, wobei defekte integrierte Schaltungen IC anschließend unter Verwendung dieser Testergebnisse bei einer Funktionsstörung in üblicher Weise markiert werden.

Ein übliches Markierverfahren ist hierbei das sogenannte "Inken", wobei funktionsgestörte integrierte Schaltungen mit einem Tintenpunkt versehen werden, der anschließend als Auswahlkriterium von nachgeschalteten Montageeinheiten zu einem Verwerfen entsprechend markierter Bausteine führt.

Nachteilig ist hierbei jedoch, dass insbesondere bei Verwendung von sogenannten Selbsttesteinheiten (BIST, Built In Self Test) die Testergebnisse in einem Speicher gespeichert werden müssen. Dies kann einerseits in flüchtigen elektrisch auslesbaren Speichern oder in nicht-flüchtigen elektrisch auslesbaren Speichern erfolgen, wobei die flüchtigen Speicher eine andauernde Stromversorgung benötigen, andererseits nicht-flüchtige Speicher erhöhte Herstellungskosten verursachen und zusätzliche gegenüber einer Standardversorgungsspannung erhöhte Spannungen benötigen.

Daher hat sich der ausschließliche Einsatz von BIST-Verfahren bzw. Selbsttestverfahren insbesondere beim Wafertest trotz des potentiell hohen Kostenvorteils immer noch nicht im breiten Umfang durchgesetzt, da nach dem Selbsttest jede integrierte Halbleiterschaltung bzw. jeder Chip IC erneut mit einem Tester kontaktiert und das Ergebnis anschließend ausgewertet werden muss. Da jedoch diese Handling- und Kontaktierzeiten einen hohen Anteil an der Testzeit und damit an den Testkosten haben, reduzieren sich die Vorteile dieser Selbsttest-Verfahren (BIST-Verfahren) erheblich.

Der Erfindung liegt daher die Aufgabe zugrunde, eine integrierte Schaltung sowie eine zugehörige gehäuste integrierte Schaltung zu schaffen, die eine Testbarkeit weiter verbessert und insbesondere die Testkosten verringert.

Erfindungsgemäß wird diese Aufgabe hinsichtlich der integrierten Schaltung durch die Merkmale des Patentanspruchs 1 und hinsichtlich der gehäusten integrierten Schaltung durch die Merkmale der Patentansprüche 10 und 13 gelöst.

Insbesondere durch Verwendung einer integrierten Selbstmarkierungsvorrichtung zum Erzeugen einer Markierung in Abhängigkeit von einem von einer Testvorrichtung ermittelten Testergebniss, kann eine üblicherweise von einer externen Markiervorrichtung aufgebrachte Markierung erstmalig selbsttätig von der integrierten Schaltung erzeugt werden.

Vorzugsweise besitzt die integrierte Selbstmarkierungsvorrichtung ein Markierelement zur Realisierung der Markierung und eine Markierelement-Aktivierungseinheit zum Aktivieren des Markierelementes, wodurch man einerseits eine sehr einfache Realisierung der Markierung erhält und andererseits bereits existierende Systeme zum Erkennen der Markierungen weiter verwenden kann.

Vorzugsweise stellt die Markierung eine nicht-flüchtige Markierung dar, wobei das Markierelement ein optisches Markierelement zur Realisierung einer optisch auslesbaren Markierung, und/oder ein elektrisches Markierelement zur Realisierung einer elektrisch auslesbaren Markierung darstellt. Im ersten Fäll und bei der erfindungsgemäßen magnetischen Markierung können die Markierungen berührungslos, d.h. ohne Kontaktierung erfasst werden, wodurch sich ein wesentlicher Zeitvorteil ergibt.

Vorzugsweise besitzt die Testvorrichtung eine integrierte Selbsttesteinheit, wodurch die Testzeit insbesondere in Verbindung mit den eingangs genannten Testverfahren wesentlich verringert werden kann. In gleicher Weise kann jedoch auch zusätzlich oder alternativ eine externe Testeinheit als Testvorrichtung verwendet werden, wodurch sich komplexere Testergebnisse auswerten lassen.

Ferner kann die integrierte Selbstmarkierungsvorrichtung eine Vielzahl von Teil-Selbstmarkierungsvorrichtungen zum Erzeugen von Teil-Markierungen in Abhängigkeit von Teil-Testergebnissen der integrierten Funktionsschaltung aufweisen, wodurch sich eine sogar Klassifizierung der getesteten integrierten Schaltungen realisieren lässt.

Ferner kann die integrierte Schaltung nicht-flüchtige Speicherelemente zum Zwischenspeichern der Testergebnisse aufweisen, wodurch sogenannte mehrstufige Tests, wie z.B. ein Wafertest und ein anschließender Produkttest unterschiedlich konfigurierbar sind.

Hinsichtlich der gehäusten integrierten Schaltung ist die integrierte Schaltung vorzugsweise in einem Gehäuse gepackt, das zumindest im Bereich der Selbstmarkierungsvorrichtung ein Material aufweist, welches das Auslesen der Markierung der integrierten Schaltung ermöglicht. Auf diese Weise können nicht nur auf Waferebene sondern auch auf Produktebene Markierungen für eine montierte integrierte Schaltung selbsttätig und unter Verwendung derselben Selbstmarkierungsvorrichtung erzeugt werden.

Das Gehäuse ist hierbei beispielsweise optisch transparent oder weist im Bereich der Selbstmarkierungsvorrichtung ein Sichtfenster auf.

Alternativ oder zusätzlich kann die gehäuste integrierte Schaltung jedoch auch eine im Gehäuse ausgebildete Gehäuse-Selbstmarkierungsvorrichtung zum Erzeugen einer getrennten Gehäuse-Markierung in Abhängigkeit von einem Testergebnis aufweisen, wobei die Gehäuse-Selbstmarkierungsvorrichtung wiederum einen gleichen Aufbau aufweist wie die integrierte Selbstmarkierungsvorrichtung der integrierten Schaltung. Auf diese Weise können Gehäusetests weiter verbessert werden.

In den weiteren Unteransprüchen sind weitere vorteilhafte Ausgestaltungen der Erfindung gekennzeichnet.

Die Erfindung wird nachstehend an Hand von Ausführungsbeispielen unter Bezugnahme auf die Zeichnung näher beschrieben.

Es zeigen:
- Figur 1: eine vereinfachte Draufsicht eines Halbleiterwafers mit integrierten Schaltungen zur Veranschaulichung eines herkömmlichen Testverfahrens;
- Figur 2: eine vereinfachte Blockdarstellung einer integrierten Schaltung mit Selbstmarkierungsvorrichtung;
- Figur 3: eine vereinfachte Blockdarstellung einer integrierten Schaltung mit Selbstmarkierungsvorrichtung gemäß einem zweiten Ausführungsbeispiel;
- Figuren 4A bis 4C: eine vereinfachte Draufsicht bzw. vereinfachte Schnittansichten einer temperatursensitiven Selbstmarkierungsvorrichtung;
- Figuren 5A und 5B: eine vereinfachte Draufsicht und eine vereinfachte Schnittansicht einer feldsensitiven Selbstmarkierungsvorrichtung; und
- Figur 6: eine vereinfachte Draufsicht einer gehäusten integrierten Schaltung.

Figur 2 zeigt eine vereinfachte Blockdarstellung einer integrierten Schaltung gemäß einem ersten Ausführungsbeispiel, wie sie beispielsweise auf einem Halbleiterwafer W gemäß Figur 1 gemeinsam mit weiteren integrierten Schaltungen IC vorliegen kann. Sie kann jedoch in gleicher Weise auch bereits als vereinzelter Halbleiterbaustein bzw. integrierte Schaltung IC vorliegen, wie dies beispielsweise nach einem Sägen der Fall ist.

Gemäß Figur 2 weist die integrierte Schaltung IC eine zu testende integrierte Funktionsschaltung 1 sowie eine Testschnittstelle TI zum Verbinden der Funktionsschaltung 1 mit einer Testvorrichtung auf, die zumindest aus einer integrierten Selbsttesteinheit 3A (BIST, Built In Self Test) besteht, wie sie üblicherweise zum Durchführen eines Selbsttests in integrierten Schaltungen ausgebildet wird. Über eine externe Testschnittstelle ETI kann beispielsweise diese Selbsttesteinheit 3A angesteuert oder mit zusätzlichen Daten während eines Selbsttestvorgangs versorgt werden. Die Testschnittstelle TI überträgt hierbei von der Testvorrichtung zu sendende Stimulus-Daten sowie von der Funktionsschaltung gesendete Antwort-Daten.

Die Testvorrichtung in Form der Selbsttesteinheit 3A führt demzufolge einen Funktionstest der integrierten Funktionsschaltung 1 zur Ermittlung eines Testergebnisses durch, wobei die Funktionsschaltung beispielsweise eine Haupt-Logikschaltung darstellt und das Testergebnis ein einfaches "pass/fail"-Ergebnis ist.

Darüber hinaus besitzt die integrierte Schaltung IC gemäß Figur 2 nunmehr eine sogenannte integrierte Selbstmarkierungsvorrichtung 2 (SMV), die eine Markierung in Abhängigkeit vom ermittelten Testergebnis der Testvorrichtung bzw. der Selbsttesteinheit 3A erzeugt.

Optional kann das ermittelte Testergebnis über eine zusätzliche strichliert dargestellte Schnittstelle TO (Testoutput) auch nach außen gegeben werden, wodurch eine zusätzliche elektrische Auswertung des Testergebnisses möglich ist.

Aufgrund der integrierten Selbstmarkierungsvorrichtung 2, die in Abhängigkeit vom Testergebnis eine Markierung vorzugsweise an der Oberfläche der integrierten Halbleiterschaltung erzeugt, entfällt somit die Notwendigkeit einer erneuten Kontaktierung nach dem Durchführen des Selbsttests, um die Testergebnisse auszulesen, auszuwerten und in Abhängigkeit von den ermittelten Testergebnissen sowie der gerade kontaktierten Halbleiterschaltung eine Markierung vorzunehmen.

Insbesondere bei dem eingangs erwähnten Testverfahren, wobei eine Vielzahl von integrierten Schaltungen IC bereits auf Waferebene einen Selbsttest gleichzeitig durchführen, erhält man eine weitere Parallelisierung durch die zeitgleiche Ausbildung von Markierungen für die einzelnen integrierten Schaltungen IC. Sowohl die Testzeit als auch die Testkosten lassen sich dadurch wesentlich verringern.

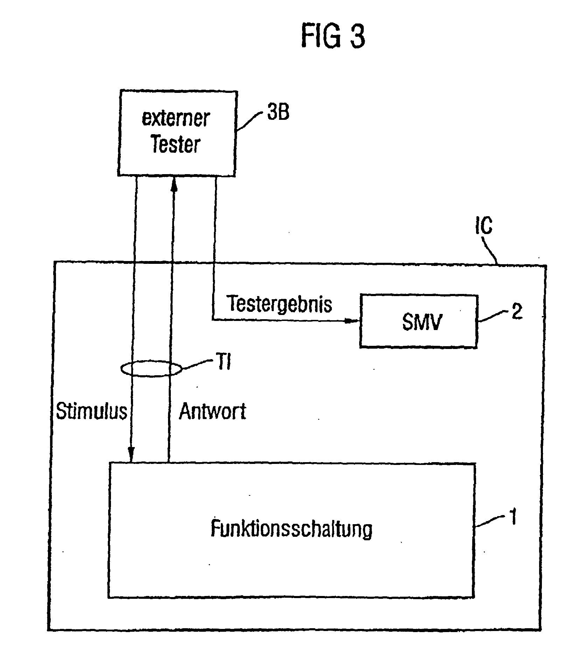

Figur 3 zeigt eine vereinfachte Blockdarstellung einer integrierten Schaltung gemäß einem zweiten Ausführungsbeispiel, wobei gleiche Bezugszeichen gleiche oder entsprechende Elemente bezeichnen und auf eine wiederholte Beschreibung nachfolgend verzichtet wird.

Gemäß Figur 3 lässt sich die vorstehende Erfindung auch auf externe Testverfahren ausweiten, wobei die Testvorrichtung nunmehr nicht länger eine integrierte Selbsttesteinheit 3A, sondern lediglich einen externen Tester 3B aufweist, der wiederum über die Testschnittstelle TI mit der zu testenden Funktionsschaltung 1 in Verbindung steht. Die Testschnittstelle TI überträgt hierbei wiederum von der Testvorrichtung zu sendende Stimulus-Daten sowie von der Funktionsschaltung gesendete Antwort-Daten.

Wiederum wird von der externen Testeinheit 3B auf der Grundlage dieser Stimulus- und Antwort-Daten ein Testergebnis ermittelt und über eine Testergebnisschnittstelle der integrierten Schaltung und insbesondere der darin integrierten Selbstmarkierungsvorrichtung 2 zugeführt. Wiederum erzeugt die integrierte Selbstmarkierungsvorrichtung 2 in Abhängigkeit von diesem Testergebnis eine Markierung an der integrierten Schaltung IC.

Gemäß diesem zweiten Ausführungsbeispiel wird der tatsächlichen Entwicklung Rechnung getragen, bei der trotz Zunahme des BIST- bzw. Selbsttestanteils bei verwendeten Testverfahren immer noch integrierte Halbleiterschaltungen IC sinnvollerweise mit externen Testeinheiten 3B und zugehörigen externen Testverfahren geprüft werden.

Gemäß einem nicht dargestellten dritten Ausführungsbeispiel ist darüber hinaus eine Kombination der in Figur 2 dargestellten internen Selbsttesteinheit 3A mit der in Figur 3 dargestellten externen Testeinheit 3B möglich und sinnvoll, wobei Teile der Funktionsschaltung 1 bzw, der integrierten Schaltung IC von einer externen Testeinheit 3B und andere Teile der integrierten Schaltung IC von einer integrierten Selbsttesteinheit 3A geprüft werden.

Insbesondere bei Verwendung von Selbsttesteinheiten 3A bietet sich jedoch die Anwendung des eingangs beschriebenen Paralleltestkonzepts gemäß Figur 1 an.

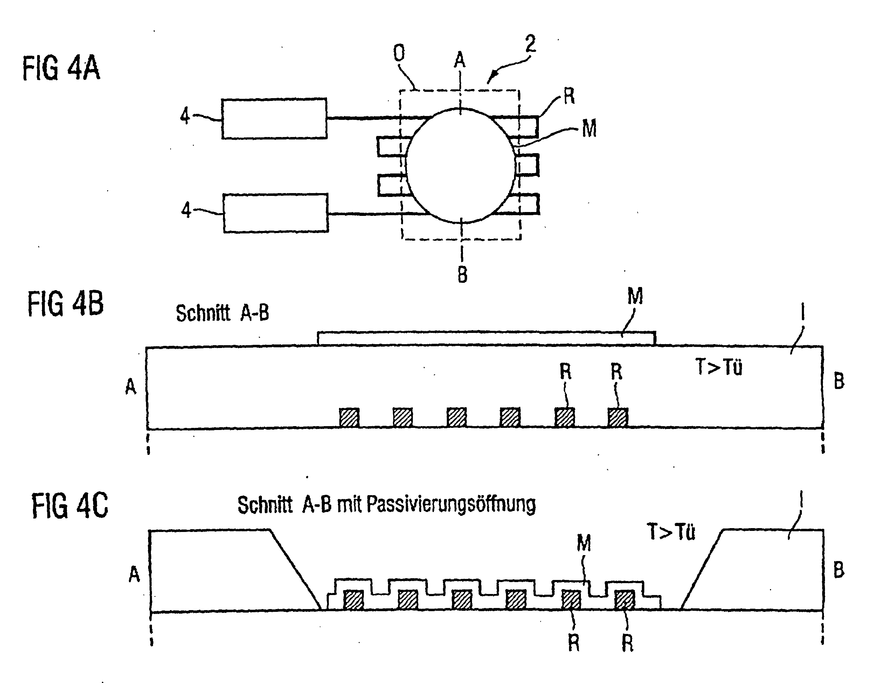

Figuren 4A bis 4C zeigen eine vereinfachte Draufsicht sowie vereinfachte Schnittansichten einer temperatursensitiven integrierten Selbstmarkierungsvorrichtung, wie sie beispielsweise in einer integrierten Schaltung IC gemäß Figur 2 oder 3 ausgebildet werden kann.

Figur 4A zeigt eine vereinfachte Draufsicht einer integrierten Selbstmarkierungsvorrichtung 2 gemäß einer ersten Ausführungsform, wie sie beispielsweise an der Oberfläche einer integrierten Schaltung IC bzw. in den obersten Schichten einer integrierten Schaltung IC ausgebildet werden kann.

Gemäß Figur 4A besteht die integrierte Selbstmarkierungsvorrichtung 2 aus einem thermosensitiven Markierelement M zur Realisierung der eigentlichen Markierung sowie aus einer Markierelement-Aktivierungseinheit zum Aktivieren des Markierelementes M. Gemäß Figur 4A handelt es sich bei der Markierelement-Aktivierungseinheit um eine sogenannte thermische Markierelement-Aktivierungseinheit, da das temperaturempfindliche Markierelement M mittels thermischer Energie bzw. aufgrund einer Temperaturänderung aktiviert wird.

Beispielsweise besitzt eine derartige thermische Markierelement-Aktivierungseinheit Anschlusselektroden 4, die über eine elektrisch leitende Leiterbahn bzw. eine Widerstandsstruktur R miteinander in Verbindung stehen.

Figur 4B zeigt eine vereinfachte Schnittansicht entlang eines Schnitts A-B von Figur 4A, wobei gleiche Bezugszeichen gleiche oder entsprechende Elemente bezeichnen und auf eine wiederholte Beschreibung nachfolgend verzichtet wird.

Gemäß Figur 4B ist die thermische Markierelement-Aktivierungseinheit im Wesentlichen als mäanderförmiger Leiterbahnbereich in einer obersten Leiterbahn- bzw. Metallisierungsebene einer integrierten Halbeiterschaltung IC ausgebildet und über eine letzte Isolations- bzw. Passivierungsschicht I vom Markierelement M getrennt bzw. beabstandet.

Im einfachsten Fall besteht demzufolge die thermische Markierelement-Aktivierungseinheit aus einer elektrisch leitenden Leiterbahn R, die sich in unmittelbarer Nähe zum Markierelement M befindet und durch Stromzufuhr erwärmt wird. Zum Anlegen des Testergebnisses an die Anschlusselektroden 4 wird beispielsweise für eine defekte integrierte Halbleiterschaltung IC ein hoher Strom in die Leiterbahn R eingeprägt, wodurch sich eine thermische Erwärmung in Abhängigkeit vom Widerstand der Leiterbahn bzw. des Widerstandselementes R ergibt. Überschreitet die Temperatur T im Bereich des Markierelementes M aufgrund dieser Erwärmung eine Übergangstemperatur T₀ des Markierelementes, bei dem das Markierelement M von einem ersten Zustand in einen zweiten Zustand übergeht, so erzeugt diese Zustandsänderung im Markierelement M die gewünschte Markierung der integrierten Halbleiterschaltung IC.

Figur 4C zeigt eine vereinfachte Schnittansicht entlang eines Schnitts A-B gemäß einer zweiten Ausführungsform der thermosensitiven Selbstmarkierungsvorrichtung 2, wobei gleiche Bezugszeichen gleiche oder entsprechende Elemente bezeichnen und auf eine wiederholte Beschreibung nachfolgend verzichtet wird.

Gemäß Figur 4C kann demzufolge im Bereich der Markierelement-Aktivierungseinheit bzw. des Widerstandselementes R eine Passivierungsöffnung O (in Figur 4A gestrichelt dargestellt) ausgebildet werden, wobei das Markierelement M unmittelbar oder mit einer sehr dünnen Isolationsschicht auf der Leiterbahn bzw. dem Widerstandselement R ausgebildet wird. Auf diese Weise erhält man eine erhöhte thermische Kopplung zwischen dem die Temperaturerhöhung verursachenden Widerstandselement R und dem Markierelement M.

Zum Ausbilden einer derartigen Öffnung können herkömmliche Ätzverfahren in Abhängigkeit von einer jeweils verwendeten Isolier- bzw. Passivierungsschicht I verwendet werden.

Zur Realisierung einer derartigen thermischen integrierten Selbstmarkierungsvorrichtung werden beispielsweise nach einem üblichen Herstellungsprozess beispielsweise zur Realisierung einer CMOS-Schaltung in der obersten Metallisierungsebene die Widerstandselemente R mit herkömmlichen Verfahren beispielsweise fotolithografisch strukturiert und abschließend ein Tropfen einer als Markierelement M geeigneten Substanz aufgebracht. Zur Auftragung des Markierelementes M können beispielsweise Tintenstrahldruckverfahren, chemische Abscheideverfahren (CVD, Chemical Vapor Deposition), Sputtern (PVD, Physical Vapor Deposition) usw. durchgeführt werden, wobei lediglich auf eine ausreichende thermische Kopplung an die Widerstandsstruktur R zu achten ist.

Als Substanz bzw. Material für das Markierelement M sind beispielsweise alle thermo-sensitiven Farbstoffe geeignet, welche einen Farbwechsel bei einer Übergangstemperatur T₀ durchlaufen. Beispielsweise kann als Markierelement M ein Calkogenidfilm, wie er von Giacomel "Eraseable optical memory employing a marman effect phase-change erasing in a calkogenide film" 1988, beschrieben ist. Eine derartige Schicht bzw. ein derartiges Material zeigt bei einer Übergangstemperatur T₀ = 200°C einen Phasenübergang von einer schwachreflektiven Phase zu einer hochreflektiven kristallinen Phase. Dieser Wechsel kann optisch ausgewertet werden, wobei beispielsweise Laserdetektoren oder CCD-Kameras verwendet werden.

In gleicher Weise sind jedoch auch Flüssigkristalle (LC, Liquid Cristal) sowie weitere Substanzen als optische Markierelemente zur Realisierung einer optisch auslesbaren Markierung geeignet.

Bei diesen optischen Markierelementen können demzufolge einfache sogenannte "pass/fail"-Informationen unmittelbar angezeigt werden, weshalb die Selbstmarkierungsvorrichtung 2 die üblicherweise notwendigen "Ink-Prozess"-Arbeitsschritte und-Anlagen ersetzt. Die vom Markierelement M erzeugte Markierung kann hierbei von bereits vorhandenen Auswertesystemen ausgewertet werden und somit ohne zusätzliche Kosten in bereits existierende Herstellungsprozesse integriert werden.

Magnetische Markierelemente können zur Realisierung einer magnetisch auslesbaren Markierung in Verbindung mit der thermischen Markierelement-Aktivierungseinheit gemäß Figuren 4A bis 4C verwendet werden.

Folglich wird ein magnetisches Markierelement M entweder gemäß Figur 4B durch eine Passivierungsschicht I beabstandet in der Nähe der Widerstandsstruktur R oder gemäß Figur 4C unmittelbar bzw. über eine sehr dünne nicht dargestellte Isolationsschicht auf der Widerstandsstruktur R ausgebildet.

Derartige magnetische Markierelemente sind beispielsweise ferromagnetische Substanzen bzw. Materialien, die in vormagnetisierter Form auf die Isolierschicht I oder unmittelbar auf die Widerstandsstruktur R aufgebracht werden. Die magnetischen Markierelemente M nutzen hierbei die Eigenschaften von vormagnetisierten ferromagnetischen Substanzen aus, wobei durch Erhitzung über eine Übergangstemperatur T₀ ihre statische Magnetisierung aufgehoben wird und sie paramagnetisch werden.

Geeignete Materialien für derartige magnetische Markierelemente M sind beispielsweise Nickel (T₀(Ni) = 649 K), Gadolinium (T₀(Gd) = 302 K) und verschiedene Legierungen.

Zum Auslesen der magnetischen Markierung wird im Gegensatz zum optischen Auslesen beispielsweise mittels Laser oder mittels einer CCD-Kamera mit nachfolgender Bildverarbeitung und Mustererkennung beispielsweise eine über dem Markierelement M schwebende Spule bzw. ein Feldsensor eingesetzt, wie er von Festplattenlaufwerken bekannt ist. Vorteilhaft ist hierbei wiederum das berührungslose Ausleseverfahren, welches schnell und materialschonend ist sowie die unsichtbarkeit der Markierung.

Ferner kann als magnetisches Material für das Markierelement M auch das aus MRAM-Speichern bekannte "giant-Magnetoresistance"-Material gewählt werden, wobei die Ansteuerung des Materials in gleicher Weise wie bei MRAM-Speichern erfolgt.

Ferner können als elektrische Markierelemente M beispielsweise Leiterbahn-Fuses, Dielektrikum-Antifuses usw. verwendet werden, wobei derartige elektrisch auslesbare Markierelemente den Nachteil einer Kontaktierung aufweisen.

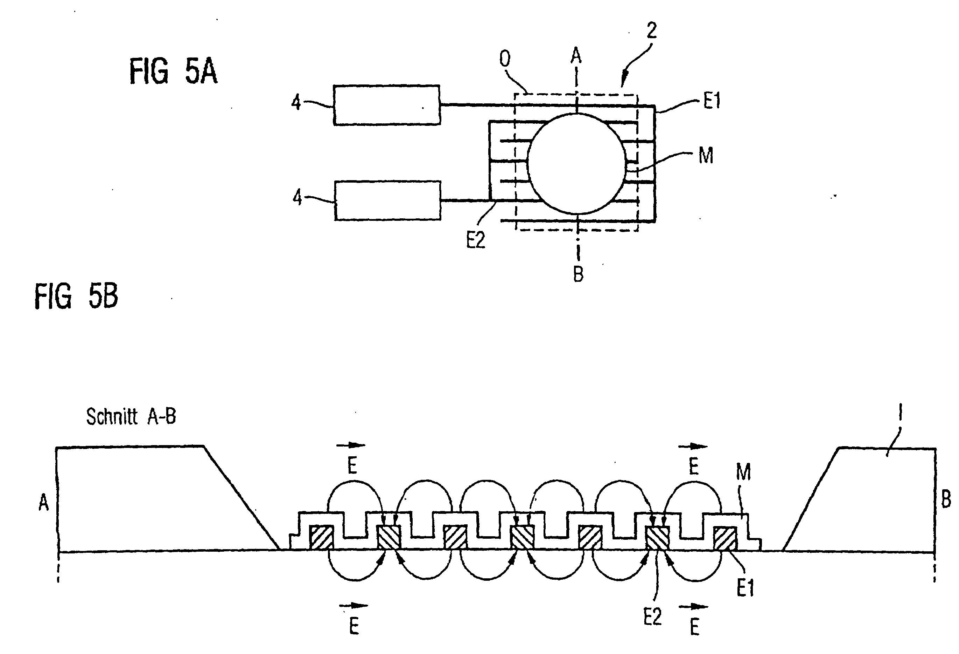

Figuren 5A und 5B zeigen eine vereinfachte Draufsicht sowie eine vereinfachte Schnittansicht einer feldsensitiven integrierten Selbstmarkierungsvorrichtung, wobei gleiche Bezugszeichen wiederum gleiche oder entsprechende Elemente wie in Figuren 4A bis 4C bezeichnen und auf eine wiederholte Beschreibung nachfolgend verzichtet wird.

Gemäß Figuren 5A und 5B ist eine E-feld aktivierte integrierte Selbstmarkierungsvorrichtung 2 dargestellt, wobei die Aktivierung des feldsensitiven Markierelementes M nunmehr nicht über eine Temperaturveränderung, sondern über eine Veränderung eines elektrischen Feldes herbeigeführt wird.

Gemäß Figur 5A besteht demzufolge die Markierelement-Aktivierungseinheit aus einer ersten Elektrode E1 und einer davon beabstandeten zweiten Elektrode E2, die wiederum jeweils mit den Anschlusselektroden 4 verbunden sind. Bei Anliegen einer Spannung bzw. eines positiven Testergebnisses wird demzufolge in den beispielsweise kammförmig verschachtelten Elektroden E1 und E2 ein elektrisches Feld E erzeugt, welches im E-Feld aktivierbaren Markierelement M eine Veränderung hervorruft.

Gemäß Figur 5B werden die Elektroden E1 und E2 wiederum in einer obersten Leiterbahnebene bzw. Metallisierungsebene ausgebildet, wobei sie beispielsweise die in Figur 5A dargestellte Kamm-Struktur aufweisen. Wiederum kann das Markierelement M über eine Isolierschicht bzw. Passivierungsschicht I von der Markierelement-Aktivierungseinheit bzw. den Elektroden E1 und E2 getrennt bzw. beabstandet sein, wobei sie sich jedoch vorzugsweise unmittelbar auf den Elektroden E1 und E2 aufgebracht ist oder lediglich durch eine sehr dünne (nicht dargestellte) Isolationschicht getrennt wird.

Als Materialien für derartige E-Feld aktivierbare bzw. feldsensitive Markierelemente M können beispielsweise die aus Flüssigkristallanzeigen bekannten Flüssigkristalle (LC, Liquid Crystal) und dergleichen verwendet werden.

Als weitere E-feldsensitive Materialien können beispielsweise elektrophoretische Substanzen (electronic ink) verwendet werden, wie sie beispielsweise von Smith "Electrostatic discharge indicator" 1999 und Comiskey "Method of manufacturing of a discrete electronic device" 1999 beschrieben sind.

Obwohl beim eingangs genannten Testverfahren insbesondere während eines Selbsttestvorgangs eine Stromversorgung vorhanden ist, werden als Materialien für die Markierelemente M vorzugsweise Materialien verwendet, die eine nicht-flüchtige Markierung hinterlassen, d.h. nach dem Wechsel der optischen oder magnetischen oder elektrischen Eigenschaften auch bei fehlender Stromversorgung kein Rückgang in den Ursprungszustand erfolgt. Auf diese Weise können auch von einer Stromversorgung abgeschaltete integrierte Schaltungen ihre Markierungen irreversibel beibehalten.

Darüberhinaus kann auch eine Vielzahl von Teil-Selbstmarkierungsvorrichtungen zum Erzeugen von Teil-Markierungen in Abhängigkeit von Teil-Testergebnissen der integrierten Funktionsschaltung in der integrierten Schaltung IC ausgebildet sein. Genauer gesagt können eine Vielzahl der vorstehend beschriebenen Selbstmarkierungsvorrichtungen 2, wie sie in Figuren 4 und 5 dargestellt sind, vorzugsweise an der Oberfläche der integrierten Schaltung IC ausgebildet werden, wodurch man die Möglichkeit einer Klassifizierung erhält.

Genauer gesagt kann dadurch beispielsweise eine optische oder magnetische Anzeige von Baustein-Geschwindigkeitsklassen selbsttätig realisiert werden. In gleicher Weise können jedoch auch Speichergrößen oder Audio-Qualitätsklassen einer integrierten Schaltung optisch oder magnetisch angezeigt werden.

Ferner können zusätzlich zu den vorstehend beschriegenen (vorzugsweise nicht-flüchtigen) Markierelementen M elektrisch auslesbare nicht-flüchtige Speicher in Form von EEPROMs, FlashPROMs, magnetischen RAMs (MRAM), ferroelektrischen RAMs (FRAM), Calkogenidspeicherv (Ovonics) usw. verwendet werden, wodurch insbesondere bei Verwendung von Selbsttesteinheiten (BIST) die aus vorherigen Testläufen gewonnenen Testergebnisse zwischengespeichert werden können und so beispielsweise ein mehrstufiger Test wie zuerst ein Wafertest und anschließend ein Produkttest unterschiedlich konfigurierbar ist.

Wiederum kann hierbei jedem Test ein eigenes (Teil-) Markierelement M zugeordnet werden, welches erst im "richtigen" Testabschnitt aktiviert wird.

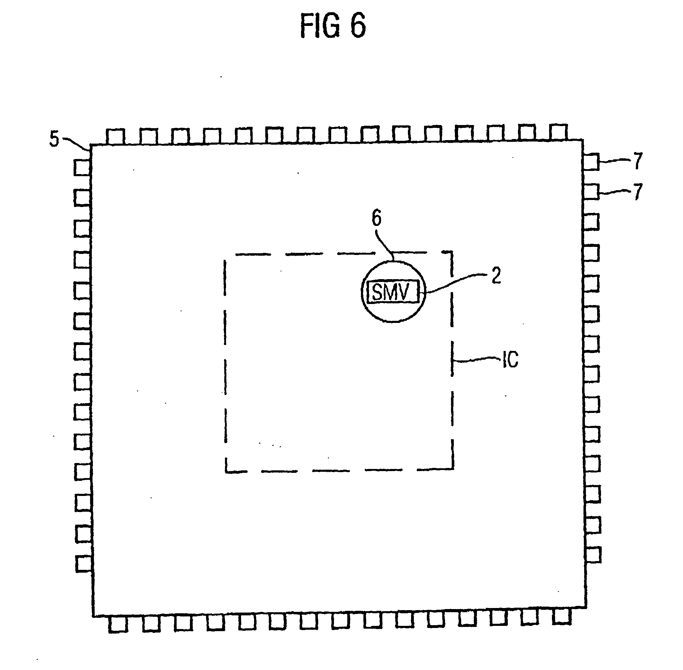

Figur 6 zeigt eine vereinfachte Draufsicht einer gehäusten integrierten Schaltung, wobei gleiche Bezugszeichen gleiche oder entsprechende Elemente wie in Figuren 1 bis 5 bezeichnen und auf eine wiederholte Beschreibung nachfolgend verzichtet wird.

Ein weiterer Vorteil der vorliegenden Erfindung ergibt sich demzufolge auch für die Verwendung in einem Produkttest bzw. für den Einsatz in endmontierten Gehäusen.

Gemäß Figur 6 ist die erfindungsgemäße integrierte Schaltung IC beispielsweise in einem Produktgehäuse 5 verpackt, welches eine Vielzahl von Anschlusspins 7 aufweist. Demzufolge kann die integrierte Selbstmarkierungsvorrichtung 2 auch für einen Produkttest bzw. Gehäusetest verwendet werden, wobei nach der Endmontage bzw. dem Verpacken im Gehäuse 5 wiederum ein externer und/oder Selbsttest durchgeführt wird.

Die interne Testschnittstelle TI bzw. externe Testschnittstelle ETI der integrierten Schaltung IC wird hierbei an speziell dafür vorgesehene Anschlusspins 7 des Produktgehäuses 5 angeschaltet, wodurch auch die endmontierte bzw. gehäuste integrierte Schaltung IC einem Funktionstest unterzogen werden kann.

Bei Verwendung von magnetischen Markierelementen bzw. elektrischen Markierelementen können hierbei sogar die üblichen Kunststoffmaterialien zum Ausbilden des Produktgehäuses 5 verwendet werden.

Sind jedoch optische Markierelemente in der Selbstmarkierungsvorrichtung 2 im Einsatz, so sollte das Gehäuse 5 zumindest im Bereich 6 der Selbstmarkierungsvorrichtung 2 ein Material aufweisen, welches das Auslesen der Markierung der integrierten Schaltung IC ermöglicht.

Beispielsweise werden demzufolge optisch transparente Kunststoffgehäuse verwendet oder ein Fenster 6 aus optisch transparentem Material im Gehäuse 5 im Bereich der Selbstmarkierungsvorrichtung 2 ausgebildet.

In gleicher Weise sollte bei Verwendung von magnetischen Markierelementen das Gehäuse 5 zumindest im Bereich 6 der Selbstmarkierungsvorrichtung 2 für derartige magnetische Felder durchlässig sein.

Gemäß einem nicht dargestellten weiteren Ausführungsbeispiel kann jedoch auch die gehäuste integrierte Schaltung eine der Selbstmarkierungsvorrichtung 2 der integrierten Schaltung IC vergleichbare Gehäuse-Selbstmarkierungsvorrichtung aufweisen, die vorzugsweise an einem Oberflächenbereich des Gehäuses 5 ausgebildet ist und zum Erzeugen einer Gehäuse-Markierung in Abhängigkeit von einem Testergebnis geeignet ist.

Der Aufbau dieser Gehäuse-Selbstmarkierungsvorrichtung entspricht hierbei im Wesentlichen dem Aufbau der vorstehend beschriebenen Selbstmarkierungsvorrichtung 2, weshalb auf eine wiederholte Beschreibung nachfolgend verzichtet wird.

Die Erfindung wurde vorstehend an Hand spezieller Materialien zur Realisierung der jeweiligen Markierelemente beschrieben. Sie ist jedoch nicht darauf beschränkt und umfasst in gleicher Weise alternative Materialien, die in gleicher Weise als Markierelemente geeignet sind.

In gleicher Weise bezieht sich die Erfindung nicht nur auf thermische und feldsensitive Selbstmarkierungsvorrichtungen, sondern entsprechende alternative Selbstmarkierungsvorrichtungen. Demzufolge ist die Erfindung nicht auf die beschriebenen temperaturempfindlichen und feldempfindlichen Materialien beschränkt sondern umfasst in gleicher Weise alternative Materialien, die in gleicher Weise als Markierelemente geeignet sind.

## Patentansprüche

1. Integrierte Schaltung mit
einer zu testenden integrierten Funktionsschaltung (1) und einer Testschnittstelle (TI, ETI) zum Verbinden der Funktionsschaltung (1) mit einer Testvorrichtung (3A; 3B), die einen Funktionstest der Funktionsschaltung (1) zur Ermittlung eines Testergebnisses durchführt,
**gekennzeichnet durch**
eine integrierte Selbstmarkierungsvorrichtung (2) zum Erzeugen von zumindest einer magnetisch auslesbaren Markierung in Abhängigkeit vom Testergebnis.

2. Integrierte Schaltung nach Patentanspruch 1, **dadurch gekennzeichnet, dass** die integrierte Selbstmarkierungsvorrichtung (2) zumindest ein magnetisches Markierelement (M) zur Realisierung der magnetisch auslesbaren Markierung und eine Markierelement-Aktivierungseinheit (4, R; E1, E2) zum Aktivieren des Markierelementes (M) aufweist.

3. Integrierte Schaltung nach Patentanspruch 1 oder 2, **dadurch gekennzeichnet, dass** die magnetisch auslesbare Markierung eine nicht-flüchtige Markierung darstellt.

4. Integrierte Schaltung nach einem der Patentansprüche 2 oder 3, **dadurch gekennzeichnet, dass** das magnetische Markierelement .(M) ein thermosensitives Markierelement darstellt und die Markierelement-Aktivierungseinheit eine Temperaturveränderung bewirkt.

5. Integrierte Schaltung nach einem der Patentansprüche 2 oder 3, **dadurch gekennzeichnet, dass** das magnetische Markierelement (M) ein feldsensitives Markierelement darstellt und die Markierelement-Aktivierungseinheit eine Veränderung eines elektrischen Feldes (E) bewirkt.

6. Integrierte Schaltung nach einem der Patentansprüche 2 bis 5, **dadurch gekennzeichnet, dass** das Markierelement ein elektrisches Markierelement zur Realisierung einer elektrisch auslesbaren Markierung und/oder ein optisches Markierelement zur Realisierung einer optisch auslesbaren Markierung darstellt.

7. Integrierte Schaltung nach einem der Patentansprüche 1 bis 6, **dadurch gekennzeichnet, dass** die Testvorrichtung eine externe Testeinheit (3B) und/oder eine integrierte Selbsttesteinheit (3A) aufweist.

8. Integrierte Schaltung nach einem der Patentansprüche 1 bis 7, **dadurch gekennzeichnet, dass** die integrierte Selbstmarkierungsvorrichtung (2) eine Vielzahl von Teil-Selbstmarkierungsvorrichtungen zum Erzeugen von Teil-Markierungen in Abhängigkeit von Teil-Testergebnissen der integrierten Funktionsschaltung (1) aufweist.

9. Integrierte Schaltung nach einem der Patentansprüche 1 bis 8, **gekennzeichnet durch** nicht-flüchtige Speicherelemente zum Zwischenspeichern der Testergebnisse.

10. Gehäuste integrierte Schaltung mit
einer integrierten Schaltung (IC) nach einem der Patentansprüche 1 bis 9, die in einem Gehäuse (5) gepackt ist, **dadurch gekennzeichnet, dass** das Gehäuse (5) zumindest in einem Bereich (6) der Selbstmarkierungsvorrichtung (2) ein Material aufweist, welches das Auslesen der Markierung der integrierten Schaltung (IC) zulässt.

11. Gehäuste integrierte Schaltung nach Patentanspruch 10, **dadurch gekennzeichnet, dass** das Gehäuse (5) zumindest im Bereich (6) der Selbstmarkierungsvorrichtung (2) für magnetische Felder durchlässig ist.

12. Gehäuste integrierte Schaltung nach einem der Patentansprüche 10 oder 11, **dadurch gekennzeichnet, dass** die Testschnittstelle (TI, ETI) der integrierten Schaltung (IC) über Anschlusspins (7) des Gehäuses (5) ansteuerbar ist.

13. Gehäuste integrierte Schaltung mit
einer zu testenden integrierten Schaltung (IC) und einer Testschnittstelle (7) zum Verbinden der integrierten Schaltung (IC) mit einer Testvorrichtung, die einen Funktionstest der integrierten Schaltung (IC) zur Ermittlung eines Testergebnisses durchführt, **gekennzeichnet durch** eine im Gehäuse (5) ausgebildete Gehäuse-Selbstmarkierungsvorrichtung zum Erzeugen einer magnetisch auslesbaren Gehäuse-Markierung in Abhängigkeit vom Testergebnis.

14. Gehäuste integrierte Schaltung nach Patentanspruch 13, **dadurch gekennzeichnet, dass** die Gehäuse-Selbstmarkierungsvorrichtung einen Aufbau aufweist wie die integrierte Selbstmarkierungsvorrichtung (2) gemäß einem der Patentansprüche 2 bis 9.

## Claims

1. Integrated circuit having
an integrated function circuit (1) which is to be tested and a test interface (TI, ETI) for connecting the function circuit (1) to a test apparatus (3A; 3B) which performs a function test on the function circuit (1) in order to ascertain a test result,
**characterized by**
an integrated self-marking apparatus (2) for producing at least one magnetically readable marking on the basis of the test result.

2. Integrated circuit according to Patent Claim 1, **characterized in that** the integrated self-marking apparatus (2) has at least one magnetic marking element (M) for producing the magnetically readable marking and a marking element activation unit (4, R; E1, E2) for activating the marking element (M).

3. Integrated circuit according to Patent Claim 1 or 2, **characterized in that** the magnetically readable marking is a non-volatile marking.

4. Integrated circuit according to either of Patent Claims 2 and 3, **characterized in that** the magnetic marking element (M) is a thermosensitive marking element, and the marking element activation unit brings about a change in temperature.

5. Integrated circuit according to either of Patent Claims 2 and 3, **characterized in that** the magnetic marking element (M) is a field-sensitive marking element, and the marking element activation unit brings about a change in an electrical field (E).

6. Integrated circuit according to one of Patent Claims 2 to 5, **characterized in that** the marking element is an electrical marking element for producing an electrically readable marking and/or an optical marking element for producing an optically readable marking.

7. Integrated circuit according to one of Patent Claims 1 to 6, **characterized in that** the test apparatus has an external test unit (3B) and/or an integrated self-test unit (3A).

8. Integrated circuit according to one of Patent Claims 1 to 7, **characterized in that** the integrated self-marking apparatus (2) has a multiplicity of self-marking apparatus components for producing marking components on the basis of test result components from the integrated function circuit (1).

9. Integrated circuit according to one of Patent Claims 1 to 8, **characterized by** non-volatile memory elements for buffer-storing the test results.

10. Packaged integrated circuit having
an integrated circuit (IC) according to one of Patent Claims 1 to 9 which is packaged in a package (5),
**characterized in that** the package (5) comprises, at least in a region (6) of the self-marking apparatus (2), a material which permits the marking on the integrated circuit (IC) to be read.

11. Packaged integrated circuit according to Patent Claim 10, **characterized in that** the package (5) is permeable to magnetic fields at least in the region (6) of the self-marking apparatus (2).

12. Packaged integrated circuit according to either of Patent Claims 10 and 11, **characterized in that** the test interface (TI, ETI) in the integrated circuit (IC) can be actuated by means of connection pins (7) on the package (5).

13. Packaged integrated circuit having
an integrated circuit (IC) which is to be tested and a test interface (7) for connecting the integrated circuit (IC) to a test apparatus which performs a function test for the integrated circuit (IC) in order to ascertain a test result, **characterized by** a package self-marking apparatus, formed in the package (5), for producing a magnetically readable package marking on the basis of the test result.

14. The packaged integrated circuit according to Patent Claim 13, **characterized in that** the package self-marking apparatus has a design like that of the integrated self-marking apparatus (2) according to one of Patent Claims 2 to 9.

## Revendications

1. Circuit intégré comprenant
un circuit (1) fonctionnel intégré à tester et une interface (TI, ETI) de test pour relier le circuit (1) fonctionnel à un dispositif (3A ; 3B) de test qui effectue un test de fonctionnement du circuit (1) fonctionnel pour déterminer un résultat de test,
**caractérisé par**
un dispositif (2) intégré d'autorepérage de production d'au moins un repérage pouvant être lu magnétiquement en fonction du résultat du test.

2. Circuit intégré suivant la revendication 1, **caractérisé en ce que** le dispositif (2) intégré d'autorepérage comporte au moins un élément (M) magnétique de repérage pour la réalisation du repérage pouvant être lu magnétiquement et une unité (4, R ; E1, E2) d'activation de l'élément (M) de repérage.

3. Circuit intégré suivant la revendication 1 ou 2, **caractérisé en ce que** le repérage pouvant être lu magnétiquement représente un repérage non volatil.

4. Circuit intégré suivant l'une des revendications 2 ou 3, **caractérisé en ce que** l'élément (M) magnétique de repérage représente un élément thermosensible de repérage et l'unité d'activation de l'élément de repérage provoque une variation de température.

5. Circuit intégré suivant l'une des revendications 2 ou 3, **caractérisé en ce que** l'élément (M) magnétique de repérage représente un élément de repérage sensible au champ et l'unité d'activation de l'élément de repérage provoque une variation d'un champ (E) électrique.

6. Circuit intégré suivant l'une des revendications 2 à 5, **caractérisé en ce que** l'élément de repérage représente un élément électrique de repérage de réalisation d'un repérage pouvant être lu électriquement et/ou un élément optique de repérage de réalisation d'un repérage pouvant être lu optiquement.

7. Circuit intégré suivant l'une des revendications 1 à 6, **caractérisé en ce que** le dispositif de test a une unité (3B) extérieure de test et/ou une unité (3A) intégrée d'autotest.

8. Circuit intégré suivant l'une des revendications 1 à 7, **caractérisé en ce que** le dispositif (2) intégré d'autorepérage a une pluralité de sous-dispositifs d'autorepérage de production de sous-repérages en fonction de résultats partiels de test du circuit (1) fonctionnel intégré.

9. Circuit intégré suivant l'une des revendications 1 à 8, **caractérisé par** des éléments de mémoire non volatils de mémorisation intermédiaire des résultats de test.

10. Circuit intégré sous boîtier comprenant
un circuit (IC) intégré suivant l'une des revendications 1 à 9, qui est mis dans un boîtier (5), **caractérisé en ce que** le boîtier (5) a, au moins dans une partie (6) du dispositif (2) d'autorepérage, un matériau qui autorise la lecture du repérage du circuit (IC) intégré.

11. Circuit intégré sous boîtier suivant la revendication 10, **caractérisé en ce que** le boîtier (5) est, au moins dans la partie (6) du dispositif (2) d'autorepérage, perméable à des champs magnétiques.

12. Circuit intégré sous boîtier suivant l'une des revendications 10 ou 11, **caractérisé en ce que** l'interface (TI, ETI) de test du circuit (IC) intégré peut être commandée par des broches (7) de connexion du boîtier (5).

13. Circuit intégré sous boîtier comprenant
un circuit (IC) fonctionnel intégré à tester et une interface (TI, ETI) de test pour relier le circuit (IC) fonctionnel à un dispositif de test qui effectue un test de fonctionnement du circuit (IC) fonctionnel pour déterminer un résultat de test,
**caractérisé par** un dispositif d'autorepérage de boîtier constitué dans le boîtier (5) de production d'un repérage de boîtier pouvant être lu magnétiquement en fonction du résultat du test.

14. Circuit intégré sous boîtier suivant la revendication 13, **caractérisé en ce que** le dispositif d'autorepérage du boîtier a la même structure que le dispositif (2) intégré d'autorepérage suivant l'une des revendications 2 à 9.
